# EUROPÄISCHE PATENTSCHRIFT

(11) **EP 1 836 841 B1**
(45) Veröffentlichungstag und Bekanntmachung des Hinweises auf die Patenterteilung: **17.10.2018**
(21) Anmeldenummer: 05817042.4
(22) Anmeldetag: 05.12.2005
(51) Int. Cl.: H05K 1/02, H01L 27/146, H04N 5/225, H05K 1/18

(54) **BILDERFASSUNGSEINRICHTUNG**
IMAGE DIGITISING DEVICE
DISPOSITIF DE DETECTION D'IMAGES

(30) Priorität: 04.01.2005 DE 102005000655
(43) Veröffentlichungstag der Anmeldung: 26.09.2007
(73) Patentinhaber: ROBERT BOSCH GMBH, 70442 Stuttgart (DE)
(72) Erfinder: DROTLEFF, Hans-Georg, 71229 Leonberg (DE); FRITZ, Steffen, 75449 Wurmberg (DE); HADELER, Michael, 72124 Pliezhausen (DE)
(86) Internationale Anmeldenummer: PCT/EP2005/056467
(87) Internationale Veröffentlichungsnummer: WO 2006/072518

(56) Entgegenhaltungen:
- EP-A2- 0 828 298
- JP-A- 7 038 789
- JP-A- 2005 117 123
- US-A1- 2002 006 687
- US-A1- 2002 080 248
- US-A1- 2004 056 956
- US-A1- 2004 085 476

## Beschreibung

### Stand der Technik

Die Erfindung betrifft eine Bilderfassungseinrichtung nach dem Oberbegriff des Anspruchs 1. Eine derartige Bilderfassungseinrichtung umfasst mindestens einen Bildsensor, der optische Signale erfasst und diese in elektrische Signale umsetzt, sowie eine elektronische Schaltungsanordnung für die Verarbeitung der von dem Bildsensor erzeugten Ausgangssignale. Üblicherweise sind der Bildsensor und die elektronische Schaltungsanordnung baulich in einem Gehäuse vereinigt, das wenigstens eine Öffnung aufweist, um dem Bildsensor die Erfassung optischer Signale zu ermöglichen. Bilderfassungseinrichtungen der gattungsgemäßen Art werden beispielsweise als Baugruppe in bordgebundenen Assistenzsystemen eingesetzt und dienen dort zur optischen Erfassung des Fahrzeugumfelds. Einerseits werden bei der heute häufig anzutreffenden digitalen Signalverarbeitung sehr hohe Taktraten verwendet. Dabei besteht das Risiko, dass Störstrahlung in die Umgebung gelangt. Andererseits sind in der Bilderfassungseinrichtung selbst gegen Störstrahlung empfindliche Bauelemente verbaut, die gegen externe Störstrahlung abgeschirmt werden müssen. Bei der Konstruktion ist daher besonders darauf zu achten, dass das Gehäuse störstrahlungsfest ausgeführt ist. Im Idealfall soll keine intern erzeugte Störstrahlung nach außen dringen. Andererseits soll aber auch das Eindringen externer Störstrahlung zuverlässig verhindert werden. Ein strahlungsdicht ausgeführtes Gehäuse ist für diese Lösung

förderlich. Bei den gattungsgemäßen Bilderfassungseinrichtungen ist jedoch durch die für den Bildsensor, bzw. dessen Optisches System, erforderliche Gehäuseöffnung eine systembedingte Schwachstelle gegeben. Da hier eine Öffnung in dem Gehäuse vorhanden ist, besteht das Risiko, dass Störstrahlung in das Gehäuse ein- oder austreten kann. Auf diese Weise werden die EMV-Eigenschaften (EMV = elektromagnetische Verträglichkeit) nachteilig beeinflusst. Es wurde bereits versucht, diesen Mangel dadurch zu beseitigen, dass auch das optische System des Bildsensors selbst mit einer eine Schirmwirkung gegen elektromagnetische Strahlung aufweisenden Schicht beschichtet wurde. Diese Lösung hat jedoch den Nachteil, dass dadurch in der Regel die optischen Eigenschaften des Bildsensors beeinträchtigt werden.

Aus US 2004/0085476 A1 ist ein elektronisches Bilderfassungssystem mit modularen Komponenten bekannt. Das Bilderfassungssystem umfasst ein Gehäuse, in dessen Rückwand wechselweise Bildsensoren mit unterschiedlichen optischen und elektronischen Eigenschaften einsetzbar sind. Das Problem einer optimalen Abschirmwirkung gegen elektromagnetische Störstrahlung ist in der Druckschrift überhaupt nicht angesprochen. Der Fachmann kann dieser Druckschrift auch keine Hinweise auf eine verbesserte Abschirmwirkung entnehmen.

Aus US 2002/0006687 A1 ist weiterhin eine integrierte Schaltungsanordnung mit einem integrierten Bildsensor bekannt. Das Abschirmproblem aufgrund störender elektromagnetischer Störstrahlung ist in der Druckschrift nicht angesprochen.

Aus EP 0 828 298 A2 ist eine Bilderfassungseinrichtung bekannt, bei der mindestens ein optischer Sensor und eine Auswerteschaltung für die Auswertung und Weiterverarbeitung von Ausgangssignalen des optischen Sensors auf einem Chip vereinigt sind. Das Problem der Verminderung von elektromagnetischer Störstrahlung ist in der Druckschrift nicht behandelt.

Aus JP-2002368481-A ist ein Abschirmgehäuse für einen elektronischen Schaltkreis bekannt, dass in seinem Randbereich Federmittel zur federnden Verbindung mit einem Träger des elektronischen Schaltkreises aufweist.

Aus JP-2003086907 A ist eine flexible Platine für eine elektronische Schaltung bekannt, die eine Abschirmschicht und eine darauf angeordnete Deckschicht trägt.

Aus JP-11239288 A ist ein Kameragehäuse mit einer Fensteröffnung für einen Bildsensor bekannt. Die Fensteröffnung ist mit elektrisch leitfähigen Gläsern verschlossen.

### Vorteile der Erfindung

Die Erfinderische Lösung mit den Merkmalen des Anspruchs 1
Bietet den Vorteil einer verbesserten Abschirmwirkung gegen elektromagnetische Störstrahlung ohne Beeinträchtigung der optischen Eigenschaften des Bildsensors. Die Erfindung macht sich die Erkenntnis zunutze, dass eine besonders gute Schirmwirkung dadurch erzielbar ist, dass die den Bildsensor tragende Platine mit einer gut leitfähigen Abschirmlage belegt ist, die ihrerseits über Verbindungsmittel mit Gehäuseleitungen auf der elektronischen Schaltungsanordnung und mit dem Gehäuse der Bilderfassungseinrichtung verbunden ist. Vorteilhaft sind die Verbindungsmittel flexibel ausgebildet. Dies erleichtert eine Montage bzw. Justierung des Bildsensors in einer bevorzugten Einbaulage. Vorteilhaft sind die Verbindungsmittel ein Teil bzw. eine Fortsetzung der Abschirmlage. Sie können so zugleich mit der Abschirmlage aus einem Nutzen ausgestanzt werden.

Weitere Vorteile und Ausgestaltungen der Erfindung gehen aus den Unteransprüchen hervor.

### Zeichnung

Die Erfindung wird nachfolgend unter Bezug auf die Zeichnung näher beschrieben. Dabei zeigt
Figur 1 eine Bilderfassungseinrichtung in Schnittdarstellung,
Figur 2 eine perspektivische Darstellung von Komponenten der Bilderfassungseinrichtung.

### Beschreibung der Ausführungsbeispiele

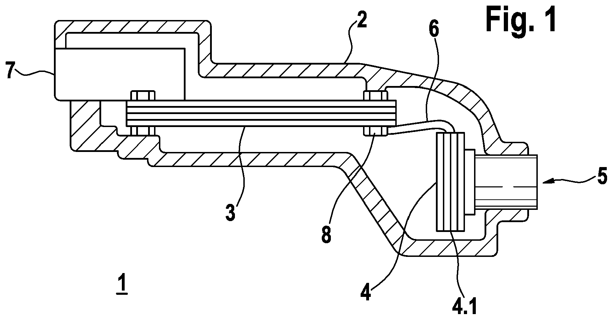

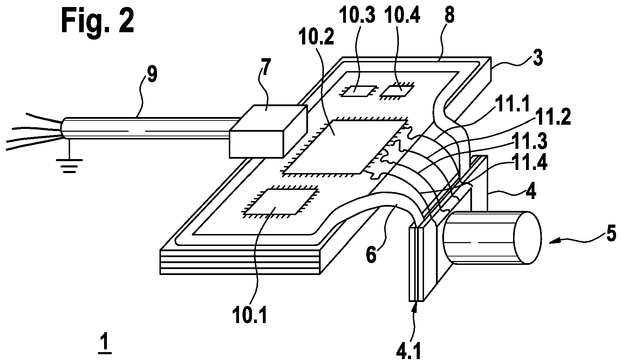

Ein Ausführungsbeispiel der Erfindung wird im Folgenden unter Bezug auf die Zeichnung beschrieben. Figur 1 zeigt eine Bilderfassungseinrichtung 1. Diese umfasst einen ggf. mit einem optischen System, wie einer Linsenkombination ausgestatteten Bildsensor 5, der auf einer Platine 4 angeordnet ist. Weiterhin umfasst das Bilderfassungssystem 1 eine Platine 3, die eine hier nicht im Detail dargestellte elektronische Schaltungsanordnung trägt. Vorzugsweise handelt es sich bei den Platinen 3 und 4 um so genannte Multilayerplatinen, mit denen vielfältige Schaltungsfunktionen raumsparend realisiert werden können. Diese Schaltungsanordnung steht in elektrischer Wirkverbindung mit dem Bildsensor 5 und dient zur Verarbeitung der von dem Bildsensor 5 abgegebenen Ausgangssignale. Der Bildsensor 5 mit seiner Platine 4 und die Platine 3 sind in einem Gehäuse 2 angeordnet. Der Bildsensor 5 ist dabei in einer Öffnung des Gehäuses 2 angeordnet, da er, ungestört durch das Gehäuse 2, optische Signale aufnehmen soll. Weiterhin ist in dem Gehäuse ein Stecker 7 vorgesehen, über den eine elektrische Verbindung zu nachgeordneten, hier nicht dargestellten, elektronischen Systemen herstellbar ist. Um trotz der wegen des Bildsensors 5 erforderlichen Öffnung in dem Gehäuse 2 eine möglichst gute Abschirmwirkung zu erreichen, ist auf der den Bildsensor 5 tragenden Platine 4 wenigstens eine Abschirmlage 4.1 angeordnet. Vorteilhaft ist diese Abschirmlage 4.1 über Verbindungsmittel 6 elektrisch gut leitend mit Gehäuseleitungen auf der Platine 3 und mit dem Gehäuse 2 verbunden. Zweckmäßig besteht die Abschirmlage 4.1 aus einem elektrisch gut leitenden Material, wie insbesondere Kupfer. Um eine flexible Justierung des Bildsensors 5 in Bezug auf die Platine 3 und/oder das Gehäuse zwei zu erleichtern, bestehen die Verbindungsmittel 6 vorzugsweise aus einem flexiblen Material, wie beispielsweise aus einer Kupferfolie. Vorteilhaft können dabei die Verbindungsmittel 6 ein Teil der Abschirmlage 4.1 oder eine Fortsetzung derselben sein. In einer Ausführungsvariante der Erfindung kann die Abschirmlage 4.1 in die als Multilayer ausgebildete Platine 4 integriert sein, also eine innere Schicht derselben bilden. In anderen Ausführungsvarianten der Erfindung kann die Abschirmlage auch auf einer Außenoberfläche der Platine 4 angebracht sein. In einer weiteren Ausführungsvariante können auch mehrere Abschirmlagen 4.1 vorgesehen sein, von denen wenigstens eine in das Innere der Platine 4 integriert und eine auf einer Außenoberfläche der Platine 4 aufgebracht ist. Die auf der Platine 3 angeordnete Gehäuseleitung ist von ihren Abmessungen her vorzugsweise so gestaltet, dass sie einen Klemmrand 8 für das Gehäuse bildet. Entsprechend angepasste Teile des vorzugsweise wenigstens zweiteiligen Gehäuses 2 kommen dann bei dem Zusammenbau der Gehäuseteile auf diesem Klemmrand 8 zu liegen und ermöglichen so einen guten galvanischen Kontakt, der die Abschirmwirkung verbessert. Figur 2 zeigt eine perspektivische Darstellung der in dem jetzt nicht gezeigten Gehäuse 2 angeordneten Komponenten. Auch hier ist wiederum deutlich sichtbar, dass durch die flexible Ausgestaltung der Verbindungsmittel 6 die Platine 4 mitsamt dem darauf angeordneten Bildsensor 5 um einen großen Winkelbereich verschwenkbar ist, so dass der Bildsensor 5 in eine optimal justierte Einbaulage gebracht werden kann. Die Verbindungsmittel 6 verbinden die in die Platine 4 integrierte Abschirmlage 4.1 mit dem Klemmrand 8 auf der Platine 3, der die auf der Oberfläche der Platine angeordneten elektronischen Komponenten 10.1,10.2,10.3,10.4 vorzugsweise ringförmig einschließt. Von der Abschirmwirkung durch den Klemmrand 8, die Verbindungsmittel 6 und die Abschirmlage 4.1 profitieren auch die hier lediglich beispielhaft dargestellten Verbindungsleitungen 11.1,11.2,11.3,11.4 zwischen der Platine 3 und der Platine 4.Zusätzlich zeigt Figur 2 noch ein in den Stecker 7 eingeführtes Verbindungskabel 9.

## Patentansprüche

1. Bilderfassungseinrichtung (1) mit einem Gehäuse (2), das eine Öffnung für einen Bildsensor (5) aufweist, mit einer auf einer Platine (3) angeordneten Schaltungsanordnung für die Verarbeitung der von dem Bildsensor (5) abgegebenen Ausgangssignale, wobei der Bildsensor (5) auf einer Platine (4) angeordnet ist, auf welcher wenigstens eine Abschirmlage (4.1) angeordnet ist und wobei Verbindungsmittel (6) zwischen der Abschirmlage (4.1) und der die Schaltungsanordnung tragenden Platine (3) ausgebildet sind, **dadurch gekennzeichnet, dass** die den Bildsensor (5) tragende Platine (4) zur Verbesserung der Abschirmwirkung des Gehäuses (2) gegen elektromagnetische Störstrahlung vor der Öffnung des Gehäuses (2) angeordnet ist, wobei die Verbindungsmittel (6) ein Teil bzw. eine Fortsetzung der Abschirmlage (4.1) selbst sind.

2. Bilderfassungseinrichtung nach Anspruch 1, **dadurch gekennzeichnet, dass** die wenigstens eine Abschirmlage (4.1) elektrisch leitend mit Gehäuseleitungen der Platine (3) und mit dem Gehäuse (2) verbunden ist.

3. Bilderfassungseinrichtung nach einem der vorhergehenden Ansprüche, **dadurch gekennzeichnet, dass** die Platinen (3,4) Multilayerplatinen sind.

4. Bilderfassungseinrichtung nach einem der vorhergehenden Ansprüche, **dadurch gekennzeichnet, dass** die Verbindungsmittel (6) zwischen der Abschirmlage (4.1) und der die Schaltungsanordnung tragenden Platine (3) flexibel ausgebildet sind.

5. Bilderfassungseinrichtung nach einem der vorhergehenden Ansprüche, **dadurch gekennzeichnet, dass** die Abschirmlage (4.1) aus einem elektrisch gut leitenden Material, wie insbesondere Kupfer, besteht.

6. Bilderfassungseinrichtung nach einem der vorhergehenden Ansprüche, **dadurch gekennzeichnet, dass** die Abschirmlage (4.1) aus einer Kupferfolie besteht.

7. Bilderfassungseinrichtung nach einem der vorhergehenden Ansprüche, **dadurch gekennzeichnet, dass** die Abschirmlage (4.1) in die als Multilayer ausgebildete Platine (4) integriert ist, also eine innere Lage der Multilayerplatine bildet.

8. Bilderfassungseinrichtung nach einem der vorhergehenden Ansprüche, **dadurch gekennzeichnet, dass** die Abschirmlage (4.1) wenigstens eine außen gelegene Schicht der Multilayerplatine (4) bildet.

9. Bilderfassungseinrichtung nach einem der vorhergehenden Ansprüche, **dadurch gekennzeichnet, dass** auf der Platine (3) angeordnete Leitungen als Gehäuseklemmrand (8) ausgebildet sind.

## Claims

1. Image capture device (1) having a housing (2), which has an opening for an image sensor (5), having a circuit arrangement for processing the output signals output by the image sensor (5), which circuit arrangement is arranged on a printed circuit board (3), wherein the image sensor (5) is arranged on a printed circuit board (4) on which at least one shielding layer (4.1) is arranged and wherein connecting means (6) are formed between the shielding layer (4.1) and the printed circuit board (3) bearing the circuit arrangement, **characterized in that** the printed circuit board (4) bearing the image sensor (5) is arranged to improve the shielding effect of the housing (2) against electromagnetic interference radiation in front of the opening of the housing (2), wherein the connecting means (6) are themselves a part or a continuation of the shielding layer (4.1).

2. Image capture device according to Claim 1, **characterized in that** the at least one shielding layer (4.1) is electrically conductively connected to housing lines of the printed circuit board (3) and to the housing (2) .

3. Image capture device according to either of the preceding claims, **characterized in that** the printed circuit boards (3, 4) are multilayer printed circuit boards.

4. Image capture device according to one of the preceding claims, **characterized in that** the connecting means (6) are formed in a flexible manner between the shielding layer (4.1) and the printed circuit board (3) bearing the circuit arrangement.

5. Image capture device according to one of the preceding claims, **characterized in that** the shielding layer (4.1) consists of a material with good electrical conductivity, such as, in particular, copper.

6. Image capture device according to one of the preceding claims, **characterized in that** the shielding layer (4.1) consists of a copper film.

7. Image capture device according to one of the preceding claims, **characterized in that** the shielding layer (4.1) is integrated into the printed circuit board (4) formed as a multilayer, that is to say forms an internal layer of the multilayer printed circuit board.

8. Image capture device according to one of the preceding claims, **characterized in that** the shielding layer (4.1) forms at least one external layer of the multilayer printed circuit board (4).

9. Image capture device according to one of the preceding claims, **characterized in that** lines arranged on the printed circuit board (3) are formed as a housing clamping rim (8).

## Revendications

1. Dispositif d'acquisition d'images (1), comprenant un boîtier (2) qui possède une ouverture pour un capteur d'images (5), comprenant un arrangement de circuit disposé sur une platine (3) pour le traitement des signaux de sortie délivrés par le capteur d'images (5), le capteur d'images (5) étant disposé sur une platine (4) sur laquelle est disposée au moins une couche de blindage (4.1) et des moyens de liaison (6) étant formés entre la couche de blindage (4.1) et la platine (3) portant l'arrangement de circuit, **caractérisé en ce que** la platine (4) qui porte le capteur d'images (5) est disposée devant l'ouverture du boîtier (2) ne vue d'améliorer l'effet de blindage du boîtier contre le rayonnement brouilleur électromagnétique, les moyens de liaison (6) étant une partie ou une continuation de la couche de blindage (4.1) elle-même.

2. Dispositif d'acquisition d'images selon la revendication 1, **caractérisé en ce que** l'au moins une couche de blindage (4.1) est reliée de manière électriquement conductrice à des lignes de boîtier de la platine (3) et au boîtier (2).

3. Dispositif d'acquisition d'images selon l'une des revendications précédentes, **caractérisé en ce que** les platines sont des platines multicouches (3, 4).

4. Dispositif d'acquisition d'images selon l'une des revendications précédentes, **caractérisé en ce que** les moyens de liaison (6) entre la couche de blindage (4.1) et la platine (3) portant l'arrangement de circuit sont de configuration flexible.

5. Dispositif d'acquisition d'images selon l'une des revendications précédentes, **caractérisé en ce que** la couche de blindage (4.1) est constituée d'un matériau bon conducteur d'électricité, comme notamment du cuivre.

6. Dispositif d'acquisition d'images selon l'une des revendications précédentes, **caractérisé en ce que** la couche de blindage (4.1) est constituée d'un film en cuivre.

7. Dispositif d'acquisition d'images selon l'une des revendications précédentes, **caractérisé en ce que** la couche de blindage (4.1) est intégrée dans la platine (4) de configuration multicouches, c'est-à-dire forme une couche interne de la platine multicouches.

8. Dispositif d'acquisition d'images selon l'une des revendications précédentes, **caractérisé en ce que** la couche de blindage (4.1) forme au moins une couche située à l'extérieur de la platine multicouches (4).

9. Dispositif d'acquisition d'images selon l'une des revendications précédentes, **caractérisé en ce que** les lignes disposées sur le platine (3) sont configurées en tant que bord de serrage du boîtier (8).
